# EUROPEAN PATENT APPLICATION

(11) **EP 4 468 375 A1**
(43) Date of publication of application: **27.11.2024**
(21) Application number: 23766437.0
(22) Date of filing: 14.02.2023
(51) Int. Cl.: H01L 33/36, H01L 33/08, H01L 33/50, H01L 33/62

(54) **SEMICONDUCTOR LIGHT EMISSION ELEMENT, SEMICONDUCTOR LIGHT EMISSION DEVICE, AND SEMICONDUCTOR LIGHT EMISSION DEVICE MODULE**

(30) Priority: 08.03.2022 JP 2022035601
(71) Applicant: Stanley Electric Co. Ltd., Tokyo 153-8636 (JP)
(72) Inventor: HIRAMA, Satoshi, Tokyo 153-8636 (JP); KONO, Keima, Tokyo 153-8636 (JP); ICHIKAWA, Koji, Tokyo 153-8636 (JP); KAMBARA, Daizo, Tokyo 153-8636 (JP); HORIO, Naochika, Tokyo 153-8636 (JP)
(74) Representative: Schmidbauer, Andreas Konrad
(86) International application number: PCT/JP2023/005010
(87) International publication number: WO 2023/171257

(57) **Abstract**

A semiconductor light emission element (10) including: a substrate (11) having insulating or semi-insulating properties; a light-emitting functional layer (15) in which a first semiconductor layer (12) having a first polarity, a light emission layer (13), and a second semiconductor layer (14) having a second polarity are sequentially laminated on the substrate (11); an insulating film (25) configured to cover the light-emitting functional layer (15); a first pad electrode (28B) and a second pad electrode (28A) electrically connected to the first semiconductor layer (12) and the second semiconductor layer (14), respectively, at least one intermediate pad (29) electrically insulated from the light-emitting functional layer (15), the first pad electrode, the second pad electrode, and the at least one intermediate pad being provided on the insulating film (25); and a pad separation groove (GP) configured to separate each of the first pad electrode (28B), the second pad electrode (28A), and the intermediate pad (29), and exposing the insulating film (25).

## Description

### Technical Field

The present invention relates to a semiconductor light emission element, a semiconductor light emission device, and a semiconductor light emission device module, and more specifically, to a semiconductor light emission element such as a light emitting diode (LED), a semiconductor light emission device including the semiconductor light emission element, and a semiconductor light emission device module.

### Background Art

In recent years, semiconductor light emission elements such as light emitting diodes (LEDs) are disposed and used in a plurality of devices in order to increase an output or control light distribution.

For example, among vehicle headlights, an adaptive driving beam (ADB) that controls light distribution according to a traveling environment is known. In addition, LED packages for high-output lighting and LED packages for information and communication equipment in which LEDs are disposed at a high density, or the like are known.

However, there is a further demand for high-output semiconductor light emission elements that can obtain uniform light emission with high light emission efficiency. Further, there is a demand for a semiconductor light emission device which has an additional function such as a protective element while preventing a deterioration in the performance of the light emission element and is less likely to cause element destruction.

For example, Patent Literature 1 discloses a light emission device that includes a plurality of hole portions formed through an active layer and exposing a first semiconductor layer, and first and second solder pads formed in regions other than positions of the plurality of hole portions, in which light field distribution is equalized and a forward voltage of the light emission device is reduced.

In addition, Patent Literature 2 discloses a light emission element structure including a plurality of semiconductor laminate layers each of which includes a plurality of grooves and a flat base having an upper surface, in which an electrode is provided on a first semiconductor layer exposed from a bottom portion of the plurality of grooves.

In addition, Patent Literature 3 discloses a nitride semiconductor light emission element in which a plurality of nitride semiconductor layers are electrically separated on the same film formation substrate and each of the nitride semiconductor layers is electrically connected to each other by a conductive wire. Patent Literature 4 discloses an LED array in which a plurality of LEDs 1 is monolithically formed in a two-dimensional manner and the plurality of LEDs is connected in series.

### Citation List

### Patent Literatures

Patent Literature 1: Japanese Patent Application Laid-Open No. 2017-92477
Patent Literature 2: Japanese Patent Application Laid-Open No. 2014-150188
Patent Literature 3: Japanese Patent Application Laid-Open No. 2001-156331
Patent Literature 4: Japanese Patent Application Laid-Open No. 2004-6582

### Summary of Invention

### Technical Problem

The present invention has been made in view of the above-described points, and an object of the present invention is to provide a semiconductor light emission element, a semiconductor light emission device, and a semiconductor light emission device module, which has heat dissipation characteristics, uniform current injection and light emission, and high light emission efficiency.

### Solution to Problem

A semiconductor light emission element according to a first embodiment of the present invention includes: a substrate having insulating or semi-insulating properties; a light-emitting functional layer in which a first semiconductor layer having a first polarity, a light emission layer, and a second semiconductor layer having a second polarity are sequentially laminated on the substrate; an insulating film configured to cover the light-emitting functional layer; a first pad electrode and a second pad electrode electrically connected to the first semiconductor layer and the second semiconductor layer, respectively, at least one intermediate pad electrically insulated from the light-emitting functional layer, the first pad electrode, the second pad electrode, and the at least one intermediate pad being provided on the insulating film; and a pad separation groove configured to separate each of the first pad electrode, the second pad electrode, and the intermediate pad, and exposing the insulating film.

### Brief Description of Drawings

FIG. 1A is a top view schematically illustrating a case in which a semiconductor light emission element 10 according to a first embodiment of the present invention is viewed from a top.
FIG. 1B is a sectional view schematically illustrating a cross-section taken along line A-A of FIG. 1A.
FIG. 2A is a perspective view illustrating a mounting method of the semiconductor light emission element 10 on a circuit board.
FIG. 2B is a top perspective view for explaining discharge of flux gas.
FIG. 2C is a sectional view for explaining the discharge of the flux gas.
FIG. 2D is a top view of a p-pad electrode 28A, an n-pad electrode 28B, or an intermediate pad electrode 29.
FIG. 3 is a diagram illustrating a relationship between a void occupancy (%) and a heat resistance (°C/W) in a bonding member.
FIG. 4 is a perspective view illustrating a semiconductor light emission device 50 and a semiconductor light emission device module 60 according to a second embodiment.
FIG. 5A is a top view schematically illustrating an upper surface of a semiconductor light emission device module 70 according to a third embodiment.
FIG. 5B is a sectional view schematically illustrating a cross-section taken along line A-A of FIG. 5A.
FIG. 6A is a top view illustrating a manufacturing step of the semiconductor light emission device module 70.
FIG. 6B is a top view illustrating a manufacturing step of the semiconductor light emission device module 70.
FIG. 6C is a top view illustrating a manufacturing step of the semiconductor light emission device module 70.
FIG. 7 is a top view schematically illustrating an upper surface of the semiconductor light emission element 80 according to a fourth embodiment.
FIG. 8 is a top view schematically illustrating a semiconductor light emission element 85 which is a modification example of the semiconductor light emission element 80.

### Description of Embodiments

Hereinafter, preferred embodiments of the present invention will be described, but these embodiments may be appropriately modified and combined. In addition, in the following description and the accompanying drawings, substantially the same or equivalent parts will be described with the same reference numerals.

### [First Embodiment]

### (1) Structure of Semiconductor Light Emission Element

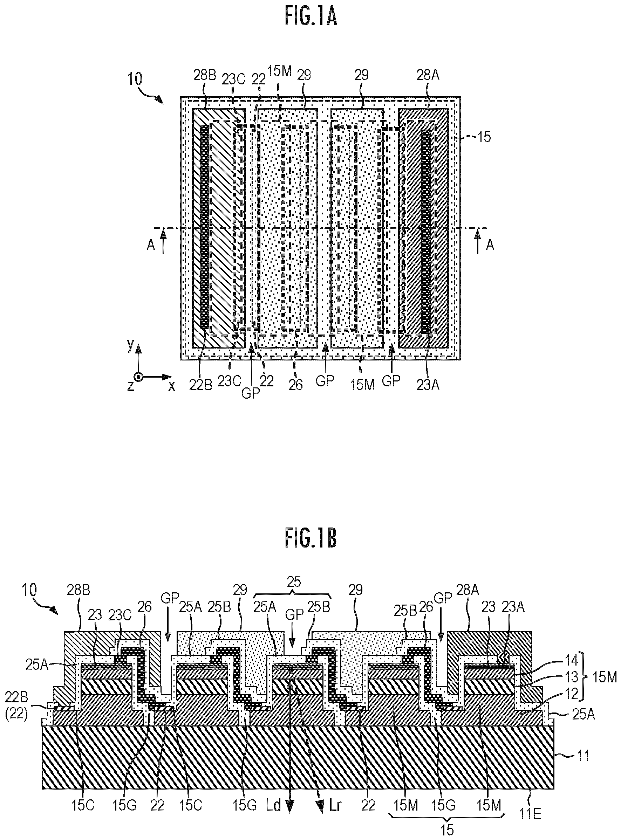

FIG. 1A is a top view schematically illustrating a case in which a semiconductor light emission element 10 according to a first embodiment of the present invention is viewed from a top (referred to as a top view). For the sake of easy description and understanding, an internal structure of an electrode and the like is also illustrated. FIG. 1B is a sectional view schematically illustrating a cross-section taken along line A-A of FIG. 1A. A structure of the semiconductor light emission element 10 will be described in detail below.

As illustrated in FIG. 1A, the semiconductor light emission element 10 includes a light-emitting functional layer 15 formed on a substrate 11. More specifically, the light-emitting functional layer 15 has a plurality of light-emitting functional portions 15M formed in a mesa shape.

As illustrated in FIG. 1B, the semiconductor light emission element 10 includes an insulating substrate 11 having light transmission properties. In the present embodiment, the substrate 11 has a rectangular columnar shape, and a surface of the substrate 11 has a rectangular shape in a top view. As the substrate 11, for example, a substrate such as sapphire and aluminum nitride (AlN) can be used.

In addition, the substrate 11 may be formed of a semi-insulating or high-resistance material, in addition to the insulating substrate. In the present specification, the substrate having semi-insulating properties includes a high-resistance GaN or the like. Specifically, the high-resistance material refers to a material having a specific resistance of 1 MΩ/□ or more.

As illustrated in FIGS. 1A and 1B, a plurality of light-emitting functional portions 15M is light emission regions separated from each other by a crystal separation groove 15G reaching the substrate 11. In addition, the plurality of light-emitting functional portions 15M extends in a direction (y direction) parallel to a pair of sides of the semiconductor light emission element 10, which faces each other.

Further, the plurality of light-emitting functional portions 15M is formed at predetermined intervals from each other in a direction (x direction) orthogonal to the extension direction. The extension direction of the light-emitting functional portion 15M is preferably a direction parallel to a predetermined crystal direction of the light-emitting functional layer 15.

More specifically, an n-type semiconductor layer 12 (first semiconductor layer having a first polarity) and a light emission layer 13 and a p-type semiconductor layer 14 (second semiconductor layer having a second polarity) are sequentially laminated on the substrate 11 to form a light-emitting functional portion 15M having a mesa shape.

The mesa-shaped light-emitting functional portion 15M is formed of a GaN-based semiconductor layer, and can be formed by separating a crystal growth layer (light-emitting functional layer), which is formed by, for example, a metal organic chemical vapor deposition (MOCVD) method, through etching. The crystal growth method is not limited to the MOCVD method, and a molecular beam epitaxy (MBE) method, a hydride vapor phase epitaxy (HVPE) method, or the like can also be used. In addition, the semiconductor layer is not limited to the GaN-based semiconductor layer, and a compound semiconductor layer capable of forming the light-emitting functional layer can be used.

The substrate 11 is exposed to a bottom surface of the crystal separation groove 15G between the light-emitting functional portions 15M. That is, each of the plurality of light-emitting functional portions 15M (semiconductor layers) is formed to be electrically separated from each other.

Further, an electrode forming portion 15C, which is a step for exposing the n-type semiconductor layer 12, is provided on one end side (-x side) of the light-emitting functional portion 15M in a horizontal direction (lateral direction). The electrode forming portion 15C extends in an extension direction (longitudinal direction) of the light-emitting functional portion 15M.

That is, an n-electrode 22 provided on the n-type semiconductor layer 12 extends in the extension direction of the light-emitting functional portion 15M. Among the plurality of light-emitting functional portions 15M, the n-electrode 22 of the light-emitting functional portion 15M positioned at an outer edge portion of the semiconductor light emission element 10 is connected to a first pad electrode (n-pad electrode) 28B described below to form an n-pad connection portion 22B.

An n-electrode 22 (first electrode), which is an ohmic electrode, is formed on the electrode forming portion 15C of the n-type semiconductor layer 12. The n-electrode 22 is formed as an ohmic electrode, which is sequentially formed of Ti and Al, on the n-type semiconductor layer 12. The n-type semiconductor layer 12 is not limited to a Ti/Al layer, and may be formed of a material for forming ohmic contact with Ti/Rh, Ti/Au, or the like.

A p-electrode 23 (second electrode) including an ohmic electrode, a reflective layer, and a protective layer is formed on the p-type semiconductor layer 14 of an upper layer of a mesa of the light-emitting functional portion 15M. Specifically, an indium tin oxide (ITO) film is used as the ohmic electrode, and a Ni/Ag/Ti/Au layer is formed on the ITO film as a reflective layer and a protective layer.

The p-electrode 23 at an outer edge portion of the other end opposite to one end side of the semiconductor light emission element 10 on which the n-pad connection portion 22B is connected to a second pad electrode (p-pad electrode) 28A, which will be described below, to form a p-pad connection portion 23A.

Side walls and an upper surfaces of the mesa-shaped light-emitting functional portion 15M and the p-electrode 23 are protected while being covered by a first insulating film 25A formed of SiO₂. A wiring layer 26, which is crossover wiring, is formed on the first insulating film 25A.

The wiring layer 26 is a light-reflective metal wiring layer and is formed to cover a part of the side walls and the upper surface of the light-emitting functional portion 15M via the first insulating film 25A. The first insulating film 25A has an opening to which the p-electrode 23 is exposed on a part of a top surface of the light-emitting functional portion 15M.

One end of the wiring layer 26 is connected to the p-electrode 23 at the opening of the first insulating film 25A to form a p-electrode connection portion 23C. In addition, the other end of the wiring layer 26 is connected to the n-electrode 22. That is, the wiring layer 26 functions as crossover wiring that connects the n-electrode 22 and the p-electrode 23 of the light-emitting functional portions 15M adjacent to each other.

Therefore, the plurality of light-emitting functional portions 15M illustrated in FIGS. 1A and 1B is connected in series. In addition, the entire plurality of the light-emitting functional portions 15M separated by the crystal separation groove 15G functions as a light-emitting functional layer and has a rectangular shape in a top view. Therefore, in the present specification, the plurality of light-emitting functional portions 15M and the crystal separation groove 15G will be collectively referred to as a light-emitting functional layer 15.

As illustrated in FIG. 1A, the p-electrode connection portion 23C and the n-electrode 22 are preferably formed from one end to the other end of the light-emitting functional portion 15M in the extension direction (y direction). In addition, it is preferable that the wiring layer 26 is formed from one end to the other end of the light-emitting functional portions 15M adjacent to each other in the extension direction in terms of reflective performance and current uniformity.

The wiring layer 26 is formed of, for example, a Ni/Al/Ti/Pt layer or a Ti/Al/Ti/Pt layer, but the layer structure thereof is not limited thereto. For example, Pd or Rh can be used instead of Pt.

The wiring layer 26 is insulated and protected while being covered with a second insulating film 25B that is formed on the wiring layer 26 and formed of SiO₂. That is, the first insulating film 25A and the second insulating film 25B are formed to cover the entire surface of the semiconductor light emission element 10 excluding the n-pad connection portion 22B and the p-pad connection portion 23A.

Hereinafter, the insulating film including the first insulating film 25A and the second insulating film 25B and covering the entire surface of the semiconductor light emission element 10 will be referred to as an element insulating film 25.

Further, the first insulating film 25A and the second insulating film 25B are not limited to SiO₂. For example, an insulating dielectric such as a SiN film can be suitably used.

As illustrated in FIG. 1A, on the surface of the element insulating film 25 of the semiconductor light emission element 10, the p-pad electrode 28A, the n-pad electrode 28B, and two intermediate pads 29 are formed to extend along the extension direction (y direction) of the light-emitting functional portion 15M and to be spaced from each other by a gap (pad separation groove GP) in a direction (x direction) perpendicular to the extension direction.

That is, the p-pad electrode 28A, the n-pad electrode 28B, and two intermediate pads 29 extending along the extension direction of the light-emitting functional portion 15M are separated from each other by pad separation grooves (hereinafter, simply referred to as grooves) GP and are arranged in a stripe shape.

It is preferable that the grooves GP are formed in a linear shape at regular intervals in the extension direction of the light-emitting functional portion 15M. In addition, it is preferable that the groove GP extends to reach outer edge portions of the crystal growth layer 15, which face each other (that is, outer edge portions parallel to the x direction). Further, the grooves GP between the adjacent pad electrode and the intermediate pad may not be equal in width.

The n-pad electrode 28B and the p-pad electrode 28A may be any conductor, but it is preferable that surface layers thereof are metal. The intermediate pad 29 is formed as an insulating pad that insulates the semiconductor layer of the semiconductor light emission element 10, that is, the light-emitting functional portion 15M.

Further, the intermediate pad 29 does not need to be a conductor and may be an insulator, but in terms of bonding and mounting, it is preferable that at least a surface layer thereof is formed of metal. In addition, it is preferable that the p-pad electrode 28A and the n-pad electrode 28B have the same layer structure, and it is more preferable that the p-pad electrode 28A, the n-pad electrode 28B, and the intermediate pad 29 have the same layer structure.

When the intermediate pad 29 is formed of a conductor such as metal and is mounted on the p-pad electrode 28A or the n-pad electrode 28B while being electrically connected to the p-pad electrode 28A or the n-pad electrode 28B, the intermediate pad 29 functions as an electrode. Hereinafter, a case in which the intermediate pad 29 is formed of a conductor such as metal will be described, and the intermediate pad 29 will be referred to as an intermediate pad electrode 29.

Specifically, as illustrated in FIG. 1B, the n-pad electrode 28B (cathode) electrically connected via an opening of the element insulating film 25 is provided on the outermost side of the n-electrode 22, which is formed on an end portion of one side of the semiconductor light emission element 10. That is, a connection portion between the n-pad electrode 28B and the n-electrode 22 is the n-pad connection portion 22B (see FIG. 1A).

Further, the p-pad electrode 28A (anode) electrically connected via the opening of the element insulating film 25 is provided on the outermost side of the p-electrode connection portion 23C, which is formed on an end portion of the other side of the semiconductor light emission element 10. That is, a connection portion between the p-pad electrode 28A and the p-electrode 23 is the p-pad connection portion 23A (see FIG. 1A).

Moreover, two intermediate pad electrodes 29 (insulating pad electrodes), which are formed on the element insulating film 25 and electrically insulated from the light-emitting functional portion 15M, are provided between the n-pad electrode 28B (cathode) and the p-pad electrode 28A (anode).

More specifically, the pad electrodes 28B and 28A and two intermediate pad electrodes 29 have an Al layer as a light reflective layer, and are formed of, for example, a Ni/Al/Ti/Au layer (the Au layer is the topmost surface layer), but the present invention is not limited thereto. For example, the light reflective layer such as an Ag layer can be used instead of the Al layer.

As illustrated in FIG. 1B, the element insulating films 25 (that is, the first insulating film 25A and the second insulating film 25B) covering the surface of the semiconductor light emission element 10 are exposed in the grooves GP between the respective pad electrodes 28B and 28A and two intermediate pad electrodes 29.

A case in which two intermediate pad electrodes 29 are disposed between the n-pad electrode 28B and the p-pad electrode 28A will be described by way of example, but the number of the intermediate pad electrodes 29 is not limited thereto. For example, at least one intermediate pad electrode 29 may be provided. The intermediate pad electrode 29 can be mounted while being appropriately divided into the n-pad electrode 28B and the p-pad electrode 28A upon mounting and being connected onto cathode wiring and anode wiring of a circuit board or the like.

A part of the light emitted from the light-emitting functional portion 15M is emitted from a light emission surface 11E, which is a back surface of the light-transmissive substrate 11, as direct light Ld, and a part of the light is emitted from the light emission surface 11E as reflected light Lr by the p-electrode 23. In addition, the light or the like emitted toward the side surface of the light-emitting functional portion 15M is also reflected by the wiring layer 26 and the pad electrodes 28A, 29, and 28B, and is emitted from the light emission surface 11E.

In the above description, a case in which the light-emitting functional layer 15 is separated into the plurality of light-emitting functional portions 15M has been described, but the light-emitting functional layer 15 may be configured as one plateau-shaped light-emitting functional portion 15M without the crystal separation groove 15G.

### (2) Mounting of Semiconductor Light Emission Element on Circuit Board

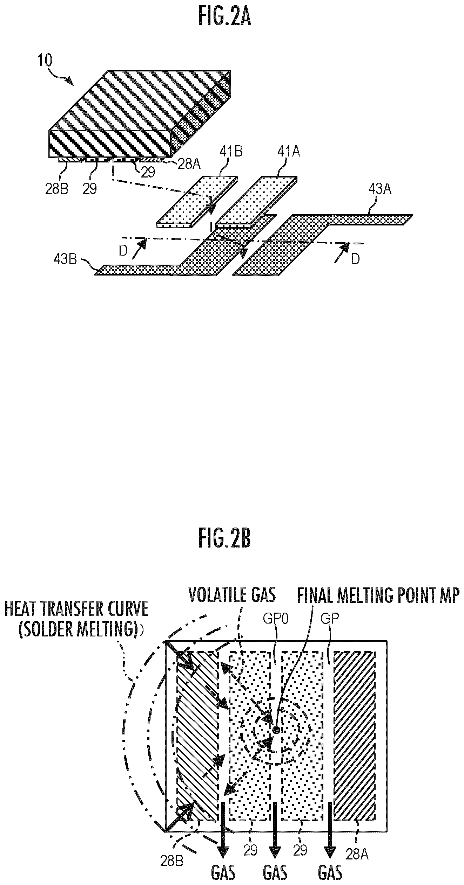

Mounting of the semiconductor light emission element 10 on the circuit board will be described below. FIG. 2A is a perspective view illustrating a mounting method of the semiconductor light emission element 10 on the circuit board.

The p-pad electrode 28A, the n-pad electrode 28B, and two intermediate pad electrodes 29 of the semiconductor light emission element 10 are turned downward, and the semiconductor light emission element 10 is bonded to anode wiring 43A and cathode wiring 43B of the circuit board using bonding members 41A and 41B.

Specifically, for example, the p-pad electrode 28A and the intermediate pad electrode 29 adjacent to the p-pad electrode 28A are bonded to the anode wiring 43A, and the n-pad electrode 28B and the intermediate pad electrode 29 adjacent to the n-pad electrode 28B are bonded to the cathode wiring 43B.

More specifically, first, a solder paste (bonding members 41A and 41B) serving as a bonding member is printed on the anode wiring 43A and the cathode wiring 43B, which are the circuit board wirings. Next, the semiconductor light emission element 10 is mounted on the solder paste. Next, the semiconductor light emission element 10 is bonded by heating in a reflow furnace.

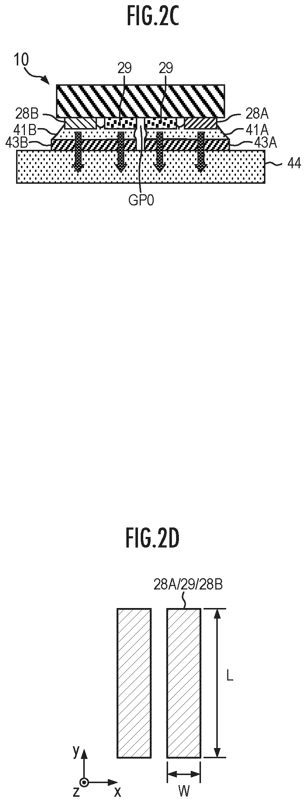

FIGS. 2B and 2C are a top perspective view and a sectional view illustrating a cross-section taken along line D-D of FIG. 2A, respectively, for describing discharge of flux gas volatilized upon the reflow.

The solder paste, which is the bonding members 41A and 41B, contains a volatile flux, and is volatilized upon reflow. In this case, as illustrated in FIG. 2B, the grooves GP between the adjacent pad electrodes among the p-pad electrode 28A, two intermediate pad electrodes 29, and the n-pad electrode 28B functions as a gas discharge passage (ventilation passage).

That is, the anode wiring 43A and the cathode wiring 43B have shapes corresponding to a bonding form of the p-pad electrode 28A, the n-pad electrode 28B, and two intermediate pad electrodes 29, and are disposed at intervals corresponding to the grooves GP. Therefore, the groove GP between the anode wiring 43A and the cathode wiring 43B functions as a ventilation passage upon the reflow.

As described above, an insulating film (SiO₂ film) having low wettability with the bonding member in a molten metal state or the solder is exposed in the groove GP between the strip-shaped pad electrodes, and the groove GP is formed well so that gas is effectively discharged.

As illustrated in FIG. 2B, when the semiconductor light emission element 10 is heated from the outside, the solder melts from the outside to the inside (in FIG. 2B, a heat transfer curve). Therefore, the groove GP is provided such that the groove GP passes through a final melting point MP (black circle, center of the light-emitting functional layer 15), it is possible to more efficiently discharge the flux gas, and it is possible to form a bonding layer with fewer voids.

Therefore, it is possible to perform mounting with high heat dissipation properties. When the light-emitting functional layer 15 has a rectangular shape as described above, it is preferable that the groove GP is provided in a disposition in which an intersection of diagonals of the light-emitting functional layer 15 is included in the groove GP.

In particular, as illustrated in FIG. 2C, a groove GP0, which is a groove between the anode wiring 43A and the cathode wiring 43B (that is, between the bonding members 41A and 41B) in which the bonding members are separated upon mounting, and which passes through the final melting point MP, has a high gas discharge effect. That is, in a case illustrated in FIG. 2C, the discharge effect of the groove GP0 between two intermediate pad electrodes 29 becomes high. A gas discharge passage GP0 is provided in this manner, so that it is particularly effective for the discharge of flux gas, it is possible to form a bonding layer for significantly suppressing generation of voids, and it is possible to perform mounting with high heat dissipation properties. It is preferable that a width of the pad separation groove GP0 is larger than a width of the other separation grooves GP.

FIG. 2D is a top view of the p-pad electrode 28A, the n-pad electrode 28B, or the intermediate pad electrode 29. In order to discharge volatile gas of flux from a portion between the adjacent pad electrodes, it is effective to increase a peripheral length L when an area S is constant. For example, the peripheral length L can be increased by subdividing the pad electrode.

Specifically, it is preferable that a ratio R = L/W of a long side (or length) L to a short side (or width) W of the pad electrode is 2 ≤ R. In addition, when R is too large, it is difficult to form and mount the electrode in terms of alignment deviation and the like, so that R ≤ 10 is preferable. Therefore, 2 ≤ R ≤ 10 is preferable. Furthermore, in consideration of discharge properties of the volatile gas and the ease of formation and mounting, a range of 3 ≤ R ≤ 8 is more preferable.

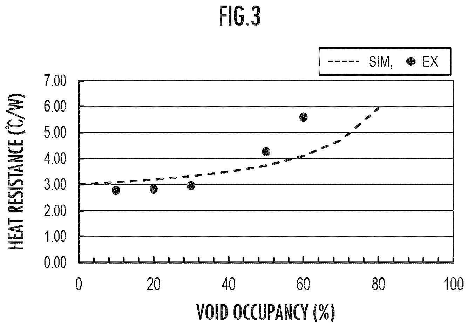

FIG. 3 is a diagram illustrating a relationship between a void occupancy (%) and a heat resistance (°C/W) when the bonding member (solder) is 1 mm in length and width. A simulation value (SIM: broken line) and an actually measured value (EX: black circle) are plotted and shown.

When the semiconductor light emission element is bonded to wiring (land) of the circuit board via the bonding member (solder), a void (hole) may be formed in the bonding member. Since the semiconductor light emission element generates heat through energization, when an occupancy of the void formed in the bonding member (an area occupied by the void in a top view) is high, a heat resistance is high, and heat dissipation characteristics to the circuit board or a heat sink (heat dissipation element) provided in the circuit board are deteriorated, which impairs reliability (for example, a lifetime) of the semiconductor light emission element.

As illustrated in FIG. 3, for example, in a case of a conventional electrode formed on the entire bottom surface of the light emission element, the void occupancy is usually 20% to 40%, and the heat resistance is increased by about 10% to 20% as compared with a case in which the void is not formed.

The pad electrode of the semiconductor light emission element 10 according to the present invention has a structure capable of discharging gas volatilized from the solder paste, which is a factor for forming the void. Accordingly, the void occupancy can be set to 0% to 15% or less. As illustrated in FIG. 3, the semiconductor light emission element 10 according to the present invention can actually obtain a void occupancy of 0% to 5%.

Therefore, since mounting with low heat resistance is possible, it is possible to provide a semiconductor light emission element having little loss in light output even in high current injection and high reliability.

[Second Embodiment]

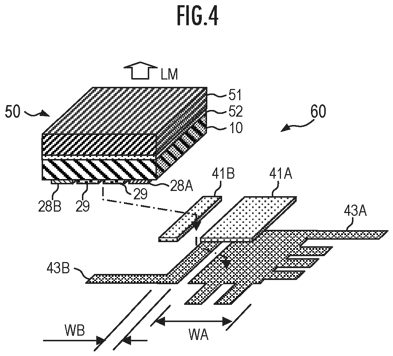

FIG. 4 is a perspective view illustrating a semiconductor light emission device 50 and a semiconductor light emission device module 60 according to a second embodiment of the present invention.

A semiconductor light emission device 50 according to the present embodiment includes the semiconductor light emission element 10 and the light guide 51 of the first embodiment. Hereinafter, a case in which the light guide 51 is a phosphor plate will be described by way of example. That is, the semiconductor light emission device 50 according to the present embodiment is configured as a light emission device that emits mixed color light.

### The semiconductor light emission device 50 includes the semiconductor light emission element 10 and a light guide provided on the semiconductor light emission element 10. More specifically, the phosphor plate 51 is adhered to the light emission surface 11E of the semiconductor light emission element 10 by the adhesive layer 52 (see

FIG. 1B).

The semiconductor light emission element 10 is, for example, a light emitting diode (LED) that emits blue light, and the phosphor plate 51 is, for example, YAG:Ce and emits yellow light as wavelength conversion light. Therefore, white mixed color light LM is emitted from an upper surface of the phosphor plate 51. As the adhesive layer 52, a light-transmissive adhesive, for example, a light-transmissive silicone resin is used.

The semiconductor light emission element 10 and the phosphor plate 51 have the same outer shape and outer size, and for example, have a rectangular plate shape. That is, the semiconductor light emission element 10 and the phosphor plate 51 have a common outer side surface. The outer shape of the phosphor plate 51 may be 5% to 10% smaller or larger than the outer shape of the semiconductor light emission element 10.

The semiconductor light emission device module 60 according to the present embodiment includes the semiconductor light emission device 50 mounted on the circuit board. More specifically, in the semiconductor light emission device module 60, the semiconductor light emission device 50 is mounted by turning downward the p-pad electrode 28A, the n-pad electrode 28B, and two intermediate pad electrodes 29 and bonding the same to the anode wiring 43A and the cathode wiring 43B of the circuit board using the bonding members 41A and 41B.

More specifically, for example, the anode wiring 43A is formed as a land having a width WA larger than a width WB of the cathode wiring 43B, the p-pad electrode 28A and two intermediate pad electrodes 29 of the semiconductor light emission device 50 are bonded to the anode wiring 43A, and the n-pad electrode 28B is bonded to the cathode wiring 43B.

As described above, since the intermediate pad electrode 29 is insulated from the light-emitting functional portion 15M, the intermediate pad electrode 29 can be used as an electrode (for example, an anode) whose heat dissipation properties are desired to be increased, and thus since a bonding area can be enlarged, the heat dissipation properties can be improved.

As described above, according to the present embodiment, since the heat dissipation properties of the semiconductor light emission device and the semiconductor light emission device module are high, it is possible to provide a semiconductor light emission device and a semiconductor light emission device module which have little loss in light output even in high current injection and high reliability in high output.

### [Third Embodiment]

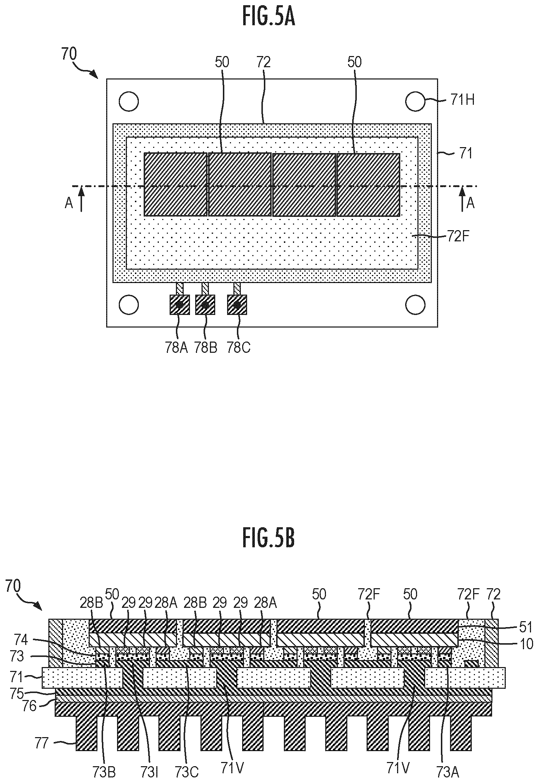

A semiconductor light emission device module 70 according to a third embodiment of the present invention will be described in detail below with reference to the accompanying drawings. FIG. 5A is a top view schematically illustrating an upper surface of the semiconductor light emission device module 70. FIG. 5B is a sectional view schematically illustrating a cross-section taken along line A-A of FIG. 5A.

The semiconductor light emission device module 70 according to the present embodiment includes a plurality of semiconductor light emission devices 50 disposed in a frame 72 standing on a circuit board 71. A case in which the frame 72 is formed as a resin dam formed of resin, for example, and four semiconductor light emission devices 50 are arranged in the frame 72 in a row will be described.

A portion between the plurality of semiconductor light emission devices 50 and the frame 72, and a portion between the plurality of semiconductor light emission devices 50 adjacent to each other are sealed with a sealing resin 72F, and an anode terminal 78A, a cathode terminal 78B, and a short-circuit detection terminal 78C connected to the plurality of semiconductor light emission devices 50 are provided. In addition, a fixing hole 71H for fixing the semiconductor light emission device module 70 is provided.

As illustrated in FIG. 5B, the plurality of semiconductor light emission devices 50 is connected in series by circuit wiring 73 of the circuit board 71. More specifically, the n-pad electrode 28B of the semiconductor light emission device 50 at one arrangement end portion (left end in FIG. 5B) is connected to cathode wiring 73B of the circuit wiring 73. In addition, the p-pad electrode 28A of the semiconductor light emission device 50 at the other arrangement end portion (right end) is connected to anode wiring 73A of the circuit wiring 73.

The p-pad electrode 28A of the semiconductor light emission device 50 and the n-pad electrode 28B of the adjacent semiconductor light emission device 50 are electrically connected to each other while being bonded to connection wiring 73C of the circuit wiring 73. Such a connection is made to connect in series the semiconductor light emission devices 50 adjacent to each other.

Further, the intermediate pad electrodes 29 of all the semiconductor light emission devices 50 are connected to intermediate wiring 73I. The intermediate wiring 73I is connected to a back surface metal layer 75 on a back surface side of the circuit board 71 through via wiring 71V formed of metal that penetrates the circuit board 71.

In this case, the anode wiring 73A is connected to the anode terminal 78A, and the cathode wiring 73B is connected to the cathode terminal 78B. In addition, the intermediate wiring 73I is connected to the short-circuit detection terminal 78C.

The back surface metal layer 75 is bonded to a heat sink 77 by a heat sink bonding layer 76. Therefore, heat generated by the semiconductor light emission device 50 is dissipated through the intermediate pad electrode 29, the intermediate wiring 73I, the via wiring 71V, the back surface metal layer 75, and the heat sink 77.

More specifically, the heat generated in the semiconductor light emission device 50 is directly dissipated to the heat sink 77 via metal (for example, copper, silver, or gold) having high heat conductivity by the intermediate electrode 29 provided in the semiconductor light emission element 10. Therefore, the heat dissipation efficiency and the light emission efficiency can be maintained high.

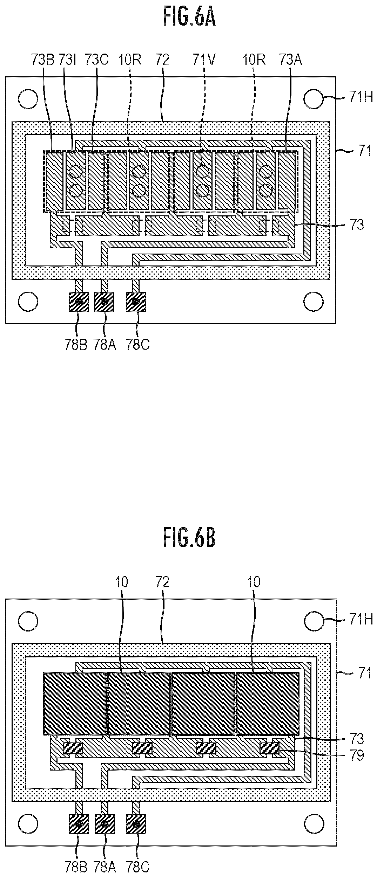

Next, a manufacturing step of the semiconductor light emission device module 70 will be described with reference to the top views illustrated in FIGS. 6A to 6C. First, as illustrated in FIG. 6A, the circuit board 71, which includes the frame 72 and the circuit wiring 73 including the anode wiring 73A, the cathode wiring 73B, the intermediate wiring 73I, and the connection wiring 73C, is prepared. In FIG. 6A, a mounting region 10R on which the semiconductor light emission element 10 is mounted is indicated by a broken line.

For example, as the circuit board 71, a glass fiber reinforced epoxy resin substrate, a metal core substrate such as an insulating layer/copper core, a ceramic substrate such as aluminum nitride or alumina, or the like can be used.

Subsequently, as illustrated in FIG. 6B, the semiconductor light emission element 10 is mounted on the mounting region 10R while being bonded by the bonding member 74. In addition, in this case, a protective element 79 such as a Zener diode is mounted on the circuit wiring 73 in parallel to each semiconductor light emission element 10. As the bonding member 74, tin copper-based lead-free solder or the like is preferable.

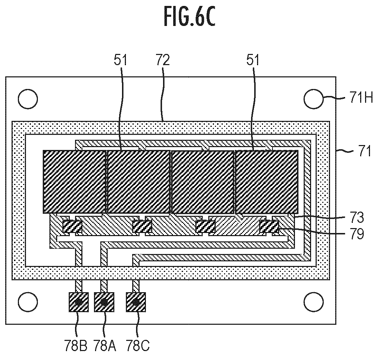

Subsequently, as illustrated in FIG. 6C, the phosphor plate 51 is adhered to the semiconductor light emission element 10 by the light-transmissive adhesive layer 52.

Finally, the sealing resin 72F is injected into an inside of the frame 72 to fill the portion between the semiconductor light emission device 50 and the frame 72 and the portion between the adjacent semiconductor light emission devices 50, thereby completing the semiconductor light emission device module 70 illustrated in FIG. 5A.

Although when the phosphor plate 51, which is a light guide, is adhered to the semiconductor light emission element 10 after the semiconductor light emission element 10 is bonded onto the circuit board 71 has been described by way of example, the semiconductor light emission device in which the light guide is adhered onto the semiconductor light emission element 10, for example, the semiconductor light emission device 50 according to the second embodiment may be mounted on the circuit board 71.

As described above, according to the present embodiment, it is possible to provide a semiconductor light emission device module having high heat dissipation properties, little loss of light output even in high current injection, and high reliability in high output, even when the plurality of semiconductor light emission devices is arranged.

### [Fourth Embodiment]

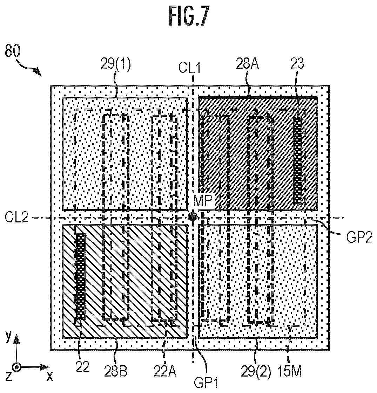

A semiconductor light emission element 80 according to a fourth embodiment of the present invention will be described in detail below with reference to the accompanying drawings. FIG. 7 is a top view schematically illustrating an upper surface of the semiconductor light emission element 80.

The semiconductor light emission element 80 according to the present embodiment is different from the semiconductor light emission element 10 according to the first embodiment in that a p-pad electrode 28A, an n-pad electrode 28B, and intermediate pad electrodes 29(1) and 29(2) are arranged in a matrix of m rows × n columns (2 ≤ m, 2 ≤ n).

More specifically, the rectangular-shaped p-pad electrode 28A, n-pad electrode 28B, and two intermediate pad electrodes 29(1) and 29(2) are arranged in two rows and two columns while being separated by a groove GP1 (y direction) and a groove GP2 (x direction). In addition, four pad electrodes are disposed symmetrically with respect to center lines CL1 and CL2 of the semiconductor light emission element 80, which are orthogonal to each other.

Further, the groove GP1 of the light-emitting functional portion 15M in the extension direction and the groove GP2 in the direction orthogonal to the extension direction are provided such that the grooves GP1 and GP2 pass through the final melting point MP, that is, the final melting point MP is positioned in the grooves GP1 and GP2.

For example, the groove GP1 and the groove GP2 are formed to pass through an intersection of the center lines CL1 and CL2 of the semiconductor light emission element 80. Alternatively, the groove GP1 and the groove GP2 may be formed to pass through a center of an outer edge (rectangular shape) of the entire four pad electrodes.

When the pad electrodes are disposed in m rows × n columns as described above, it is effective in terms of discharging gas to provide the grooves GP1 and GP2 passing through the final melting point MP among the grooves GP between the pad electrodes. In a case illustrated in FIG. 7, the grooves GP1 and GP2 function as separation grooves GP1 and GP2 having particularly high gas discharge effect.

Furthermore, the p-pad electrode 28A and the n-pad electrode 28B are disposed at diagonal positions. In this case, the p-pad electrode 28A and the intermediate pad electrode 29(1) are connected to the anode wiring of the circuit board, and the n-pad electrode 28B and the intermediate pad electrode 29(2) are connected to the cathode wiring, that is, a form can be adopted in which the intermediate pad electrodes are combined in a row direction (x direction). Alternatively, a form can be taken in which the intermediate pad electrode and the p-pad electrode 28A or the n-pad electrode 28B are combined in a column direction (y direction). Alternatively, combinations can be made according to a heat dissipation design, such as combination of the p-pad electrode 28A and two intermediate pad electrodes 29(1) and 29(2) or a single use of the n-pad electrode 28B. Therefore, it is possible to provide a semiconductor light emission device module having high heat dissipation properties. In addition, mounting properties are also high, such as being able to be mounted by rotating by 90°.

In particular, in a case of the semiconductor light emission device module in which the plurality of semiconductor light emission elements 80 is arranged, the pad electrodes are combined according to a disposition position or the like of each semiconductor light emission element 80, so that it is possible to provide a semiconductor light emission device module having high heat dissipation properties, high heat dissipation uniformity, and high light output uniformity.

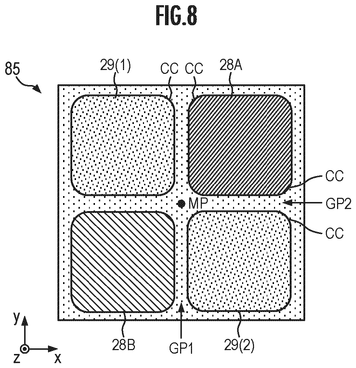

FIG. 8 is a top view schematically illustrating a semiconductor light emission element 85 which is a modification example of the semiconductor light emission element 80. The semiconductor light emission element 85 illustrated in FIG. 8 is different from the semiconductor light emission element 80 illustrated in FIG. 7 in that a chamfered portion CC, which is formed by chamfering corner portions of the rectangular-shaped p-pad electrode 28A, n-pad electrode 28B, and two intermediate pad electrodes 29(1) and 29(2), is provided, and the other configurations thereof are the same.

With such a configuration, since the end portions of the grooves GP1 and GP2 serving as gas discharge passages are expanded, discharge properties of the flux gas are improved. A shape of the chamfered portion CC may be a curved shape or a linear shape. In addition, it is preferable that four corners of the p-pad electrode 28A, the n-pad electrode 28B, and two intermediate pad electrodes 29(1) and 29(2) are chamfered.

The semiconductor light emission element 80 in which the pad electrodes are arranged in a matrix has been described, but the present invention is not limited thereto. The configuration of the pad electrode according to the present embodiment can also be applied to a semiconductor light emission device in which a light guide such as a phosphor plate is adhered to the semiconductor light emission element 80, and a semiconductor light emission device module in which a plurality of the semiconductor light emission devices is arranged and mounted, and the same effects as described above can be obtained.

As described in detail above, according to the present invention, it is possible to provide a semiconductor light emission element, a semiconductor light emission device, and a semiconductor light emission device module, which has high heat dissipation performance, little loss of light output even in high current injection, and high reliability in high output.

### Description of Reference Numerals

10, 80, 85: semiconductor light emission element
11: substrate
12: first semiconductor layer
13: light emission layer
14: second semiconductor layer
15: light-emitting functional layer
15M: light-emitting functional crystal portion
15G: crystal separation groove
22: n-electrode (first electrode)
22B: n-pad connection portion
23: p-electrode (second electrode)
23A: p-pad connection portion
25: element insulating film
25A: first insulating film
25B: second insulating film
26: wiring layer
28A: second pad electrode (p-pad electrode)
28B: first pad electrode (n-pad electrode)
29: intermediate pad
43A: anode wiring
43B: cathode wiring
50: semiconductor light emission device
51: light guide (phosphor plate)
60, 70: semiconductor light emission device module
71: circuit board
72: frame
72F: sealing resin
GP: pad separation groove
MP: final melting point
77: heat sink

## Claims

1. A semiconductor light emission element, comprising:
a substrate having insulating or semi-insulating properties;
a light-emitting functional layer in which a first semiconductor layer having a first polarity, a light emission layer, and a second semiconductor layer having a second polarity are sequentially laminated on the substrate;
an insulating film configured to cover the light-emitting functional layer;
a first pad electrode and a second pad electrode electrically connected to the first semiconductor layer and the second semiconductor layer, respectively, and at least one intermediate pad electrically insulated from the light-emitting functional layer, the first pad electrode, the second pad electrode, and the at least one intermediate pad being provided on the insulating film; and
a pad separation groove configured to separate each of the first pad electrode, the second pad electrode, and the intermediate pad, and to expose the insulating film.

2. The semiconductor light emission element according to claim 1,
wherein the pad separation groove extends to reach outer edge portions of the light-emitting functional layer, which face each other.

3. The semiconductor light emission element according to claim 1 or 2,
wherein the light-emitting functional layer has a rectangular shape in a top view, and the pad separation groove is provided in a disposition including an intersection of diagonals of the light-emitting functional layer.

4. The semiconductor light emission element according to any one of claims 1 to 3,
wherein the light-emitting functional layer has a pair of sides facing each other, and includes a plurality of mesa-shaped light-emitting functional portions separated by a crystal separation groove exposing the substrate and extending in a direction parallel to the pair of sides.

5. The semiconductor light emission element according to claim 4,
wherein the first pad electrode, the second pad electrode, and the intermediate pad are disposed in a stripe shape by extending in an extension direction of the plurality of light-emitting functional portions.

6. The semiconductor light emission element according to any one of claims 1 to 5,
wherein the first pad electrode, the second pad electrode, and the intermediate pad are arranged in a matrix.

7. The semiconductor light emission element according to any one of claims 1 to 6,
wherein the first pad electrode, the second pad electrode, and the intermediate pad have chamfered portions having chamfered corner portions.

8. The semiconductor light emission element according to any one of claims 4 to 7, further comprising: a wiring layer configured to connect the light-emitting functional portions adjacent to each other in series, and provided across one end to the other end of the light-emitting functional portions adjacent to each other in the extension direction.

9. The semiconductor light emission element according to any one of claims 1 to 8,
wherein the first pad electrode, the second pad electrode, and the intermediate pad have a same layer structure.

10. A semiconductor light emission device comprising:
the semiconductor light emission element according to any one of claims 1 to 9; and
a light guide provided on the semiconductor light emission element.

11. The semiconductor light emission device according to claim 10,
wherein the light guide is a phosphor plate.

12. A semiconductor light emission module comprising:
a circuit board having first wiring and second wiring on a surface; and
the semiconductor light emission element according to any one of claims 1 to 9,
wherein the first pad electrode and the second pad electrode of the semiconductor light emission element are bonded to the first wiring and the second wiring by a first bonding member and a second bonding member, respectively, and
at least one intermediate pad of the semiconductor light emission element is bonded to the first wiring or the second wiring.

13. A semiconductor light emission module comprising:
a circuit board having first wiring, second wiring, and third wiring on a surface; and
the semiconductor light emission element according to any one of claims 1 to 9
wherein the first pad electrode and the second pad electrode of the semiconductor light emission element are bonded to the first wiring and the second wiring by a first bonding member and a second bonding member, respectively, and
at least one intermediate pad of the semiconductor light emission element is bonded to the third wiring while being electrically insulated from the first wiring and the second wiring.

14. A semiconductor light emission module comprising:
a circuit board having first wiring and second wiring on a surface; and
the semiconductor light emission device according to claim 10 or 11,
wherein the first pad electrode and the second pad electrode of the semiconductor light emission device are bonded to the first wiring and the second wiring by a first bonding member and a second bonding member, respectively, and
at least one intermediate pad of the semiconductor light emission device is bonded to the first wiring or the second wiring.

15. A semiconductor light emission module comprising:
a circuit board having first wiring, second wiring, and third wiring on a surface; and
the semiconductor light emission device according to claim 10 or 11,
wherein the first pad electrode and the second pad electrode of the semiconductor light emission device are bonded to the first wiring and the second wiring by a first bonding member and a second bonding member, respectively, and
at least one intermediate pad of the semiconductor light emission device is bonded to the third wiring while being electrically insulated from the first wiring and the second wiring.

16. The semiconductor light emission module according to claim 13 or 15, further comprising:
a heat dissipation element,
wherein the at least one intermediate pad is thermally bonded to the heat dissipation element.

17. The semiconductor light emission module according to claim 12 or 14,
wherein the first wiring and the second wiring have shapes corresponding to the first pad electrode and the second pad electrode, respectively, and are disposed at an interval corresponding to the pad separation groove.

18. The semiconductor light emission module according to claim 13, 15, or 16,
wherein the first wiring, the second wiring, and the third wiring have shapes corresponding to the first pad electrode, the second pad electrode, and the intermediate pad, respectively, and are disposed at an interval corresponding to the pad separation groove.

## Amended claims

### Amended claims under Art. 19.1 PCT

1. A semiconductor light emission element comprising:
a substrate having insulating or semi-insulating properties;
a light-emitting functional layer in which a first semiconductor layer having a first polarity, a light emission layer, and a second semiconductor layer having a second polarity are sequentially laminated on the substrate;
an insulating film configured to cover the light-emitting functional layer;
a first pad electrode and a second pad electrode electrically connected to the first semiconductor layer and the second semiconductor layer, respectively, and at least one intermediate pad electrically insulated from the light-emitting functional layer, the first pad electrode, the second pad electrode, and the at least one intermediate pad being provided on the insulating film; and
a pad separation groove separating each of the first pad electrode, the second pad electrode, and the intermediate pad, and exposing the insulating film,
wherein the light-emitting functional layer includes a plurality of mesa-shaped light-emitting functional portions separated by a crystal separation groove exposing the substrate and extending in a direction parallel to each other.

2. The semiconductor light emission element according to claim 1,
wherein the pad separation groove extends to reach outer edge portions of the light-emitting functional layer, which face each other.

3. The semiconductor light emission element according to claim 1 or 2,
wherein the light-emitting functional layer has a rectangular shape in a top view, and the pad separation groove is provided in a disposition including an intersection of diagonals of the light-emitting functional layer.

4. The semiconductor light emission element according to any one of claims 1 to 3,
wherein the light-emitting functional layer has a pair of sides facing each other, and the plurality of light-emitting functional portions extends in a direction parallel to the pair of sides.

5. The semiconductor light emission element according to claim 4,
wherein the first pad electrode, the second pad electrode, and the intermediate pad are disposed in a stripe shape by extending in an extension direction of the plurality of light-emitting functional portions.

6. The semiconductor light emission element according to any one of claims 1 to 5,
wherein the first pad electrode, the second pad electrode, and the intermediate pad are arranged in a matrix.

7. The semiconductor light emission element according to any one of claims 1 to 6,
wherein the first pad electrode, the second pad electrode, and the intermediate pad have chamfered portions having chamfered corner portions.

8. The semiconductor light emission element according to any one of claims 4 to 7, further comprising: a wiring layer configured to connect the light-emitting functional portions adjacent to each other in series, and provided across one end to the other end of the light-emitting functional portions adjacent to each other in the extension direction.

9. The semiconductor light emission element according to any one of claims 1 to 8,
wherein the first pad electrode, the second pad electrode, and the intermediate pad have a same layer structure.

10. A semiconductor light emission device comprising:
the semiconductor light emission element according to any one of claims 1 to 9; and
a light guide provided on the semiconductor light emission element.

11. The semiconductor light emission device according to claim 10,
wherein the light guide is a phosphor plate.

12. A semiconductor light emission module comprising:
a circuit board having first wiring and second wiring on a surface; and
the semiconductor light emission element according to any one of claims 1 to 9,
wherein the first pad electrode and the second pad electrode of the semiconductor light emission element are bonded to the first wiring and the second wiring by a first bonding member and a second bonding member, respectively, and
at least one intermediate pad of the semiconductor light emission element is bonded to the first wiring or the second wiring.

13. A semiconductor light emission module comprising:
a circuit board having first wiring, second wiring, and third wiring on a surface; and
the semiconductor light emission element according to any one of claims 1 to 9
wherein the first pad electrode and the second pad electrode of the semiconductor light emission element are bonded to the first wiring and the second wiring by a first bonding member and a second bonding member, respectively, and
at least one intermediate pad of the semiconductor light emission element is bonded to the third wiring while being electrically insulated from the first wiring and the second wiring.

14. A semiconductor light emission module comprising:
a circuit board having first wiring and second wiring on a surface; and
the semiconductor light emission device according to claim 10 or 11,
wherein the first pad electrode and the second pad electrode of the semiconductor light emission device are bonded to the first wiring and the second wiring by a first bonding member and a second bonding member, respectively, and
at least one intermediate pad of the semiconductor light emission device is bonded to the first wiring or the second wiring.

15. A semiconductor light emission module comprising:
a circuit board having first wiring, second wiring, and third wiring on a surface; and
the semiconductor light emission device according to claim 10 or 11,
wherein the first pad electrode and the second pad electrode of the semiconductor light emission device are bonded to the first wiring and the second wiring by a first bonding member and a second bonding member, respectively, and
at least one intermediate pad of the semiconductor light emission device is bonded to the third wiring while being electrically insulated from the first wiring and the second wiring.

16. The semiconductor light emission module according to claim 13 or 15, further comprising:
a heat dissipation element,
wherein the at least one intermediate pad is thermally bonded to the heat dissipation element.

17. The semiconductor light emission module according to claim 12 or 14,
wherein the first wiring and the second wiring have shapes corresponding to the first pad electrode and the second pad electrode, respectively, and are disposed at an interval corresponding to the pad separation groove.

18. The semiconductor light emission module according to claim 13, 15, or 16,
wherein the first wiring, the second wiring, and the third wiring have shapes corresponding to the first pad electrode, the second pad electrode, and the intermediate pad, respectively, and are disposed at an interval corresponding to the pad separation groove.

Statement under Art. 19.1 PCT
The amended claim 1 is obtained by adding the description "wherein the light-emitting functional layer includes a plurality of mesa-shaped light-emitting functional portions separated by a crystal separation groove for exposing the substrate and extending in a direction parallel to each other" to claim 1 at the time of filing. This amendment is based on the description such as the claims 4 at the time of filing, paragraphs [0017] and [0018] of the specification, and FIGS. 1A and 1B.

The amended claim 4 is obtained by removing the description that overlaps the amended matters in claim 1 from claim 4 at the time of filing.
